# EUROPEAN PATENT APPLICATION

(11) **EP 4 685 845 A1**
(43) Date of publication of application: **28.01.2026**
(21) Application number: 25183412.3
(22) Date of filing: 17.06.2025
(51) Int. Cl.: H01L 23/00, H01L 25/065

(54) **THREE-DIMENSIONAL INTEGRATED CIRCUIT**

(30) Priority: 26.07.2024 KR 20240099706; 28.11.2024 KR 20240173949
(71) Applicant: Samsung Electronics Co., Ltd., Suwon-si, Gyeonggi-do 16677 (KR)
(72) Inventor: HONG, Yongjin, 16677 Suwon-si (KR); KIM, Kiok, 16677 Suwon-si (KR); KIM, Wook, 16677 Suwon-si (KR)
(74) Representative: Marks & Clerk LLP

(57) **Abstract**

Provided is a three-dimensional integrated circuit. The three-dimensional integrated circuit includes: a first die having a first surface and a second surface opposite each other; and a second die vertically stacked on the first surface of the first die. The first die includes: a functional block arranged on the first surface of the first die; and a plurality of conductive terminals arranged on the functional block and electrically connecting the first die to the second die. The plurality of conductive terminals include a plurality of edge conductive terminals arranged on an edge region of the functional block, and the plurality of edge conductive terminals are each spaced apart from a boundary of the functional block by a first distance that is greater than or equal to a minimum distance between the plurality of conductive terminals.

## Description

### BACKGROUND

The present disclosure relates to a three-dimensional integrated circuit, and more specifically, to a three-dimensional integrated circuit including a plurality of conductive terminals.

The need for miniaturization, multifunctionality, and high performance in electronic products requires high-capacity integrated circuit devices. To provide high-capacity integrated circuit devices, integration may be increased. To increase integration, three-dimensional integrated circuits in which a plurality of chips or a plurality of dies are vertically stacked are being developed. The three-dimensional integrated circuits may include a plurality of conductive terminals for connecting the plurality of dies, and in order to improve the performance and area efficiency of the three-dimensional integrated circuits, a method of efficiently arranging the plurality of conductive terminals may be required.

### SUMMARY

One or more example embodiments provide a three-dimensional integrated circuit that may prevent short circuits or disconnections of conductive terminals between vertically stacked dies and may have improved power, performance, and area (PPA).

According to an aspect of an example embodiment, a three-dimensional integrated circuit includes: a first die having a first surface and a second surface opposite each other; and a second die vertically stacked on the first surface of the first die. The first die includes: a functional block arranged on the first surface of the first die; and a plurality of conductive terminals arranged on the functional block and electrically connecting the first die to the second die. The plurality of conductive terminals include a plurality of edge conductive terminals arranged on an edge region of the functional block. The plurality of edge conductive terminals are each spaced apart from a boundary of the functional block by a first distance that is greater than or equal to a minimum distance between the plurality of conductive terminals.

According to another aspect of an example embodiment, a three-dimensional integrated circuit includes: a first die having a first surface and a second surface opposite each other; and a second die vertically stacked on the first surface of the first die. The first die includes: a functional block arranged on the second surface; and a plurality of conductive terminals arranged on the first surface, overlapping the functional block along a vertical direction, and electrically connecting the first die to the second die. The plurality of conductive terminals include a plurality of edge conductive terminals overlapping an edge region of the functional block. The plurality of edge conductive terminals are each spaced apart from a boundary of the functional block by a first distance that is greater than or equal to a minimum distance between the plurality of conductive terminals.

According to another aspect of an example embodiment, a three-dimensional integrated circuit includes: a first die including a functional block; and a second die vertically stacked on the first die and electrically connected to the first die through a plurality of conductive terminals. The plurality of conductive terminals include: first conductive terminals overlapping the functional block along a vertical direction; second conductive terminals overlapping the functional block along the vertical direction; and peripheral conductive terminals not overlapping the functional block along the vertical direction. The first conductive terminals are each spaced apart from a boundary of the functional block by a first distance that is greater than or equal to a minimum distance between the plurality of conductive terminals. The second conductive terminals overlap an inner region of the functional block and are spaced apart from each other by a second distance that is between the first distance and twice the first distance.

At least some of the above and other features of the invention are set out in the claims.

### BRIEF DESCRIPTION OF DRAWINGS

The above and other aspects and features will be more apparent from the following description of example embodiments, taken in conjunction with the accompanying drawings, in which:
FIGS. 1A and 1B each show a three-dimensional integrated circuit according to some example embodiments;
FIGS. 2A and 2B each show a three-dimensional integrated circuit according to some example embodiments;
FIGS. 3A and 3B each show a three-dimensional integrated circuit according to comparative examples;
FIG. 4 is a plan view showing a die according to an example embodiment;
FIG. 5 is a plan view showing a functional block according to an example embodiment;
FIGS. 6A, 6B and 6C are plan views showing a functional block according to some example embodiments;
FIG. 7 is a cross-sectional view of a functional block according to an example embodiment;
FIG. 8 is a cross-sectional view of a functional block according to an example embodiment;
FIG. 9 is a plan view showing a die according to an example embodiment;
FIGS. 10A and 10B each show a functional block according to some example embodiments;
FIG. 11 is a plan view showing a die according to a comparative example and a die according to an example embodiment;
FIGS. 12 to 16 each show a three-dimensional integrated circuit according to some example embodiments;
FIGS. 17 and 18 each show a three-dimensional integrated circuit according to some example embodiments;
FIG. 19 shows a high bandwidth memory (HBM) apparatus according to an example embodiment; and
FIG. 20 is a flowchart showing a method of manufacturing a three-dimensional integrated circuit, according to an example embodiment.

### DETAILED DESCRIPTION

Hereinafter, embodiments will be described in detail with reference to the accompanying drawings. The same reference numerals are used to denote the same elements in the drawings, and repeated descriptions thereof will be omitted.

In the present specification, an X-axis direction may be referred to as a first direction, a Y-axis direction may be referred to as a second direction, and a Z-axis direction may be referred to as a vertical direction. A plane formed by an X-axis and a Y-axis may be referred to as a horizontal plane, a component relatively arranged in a +Z-axis direction in comparison to another component may be referred to as being over the other component, and a component relatively arranged in a -Z-axis direction in comparison to another component may be referred to as being under the other component.

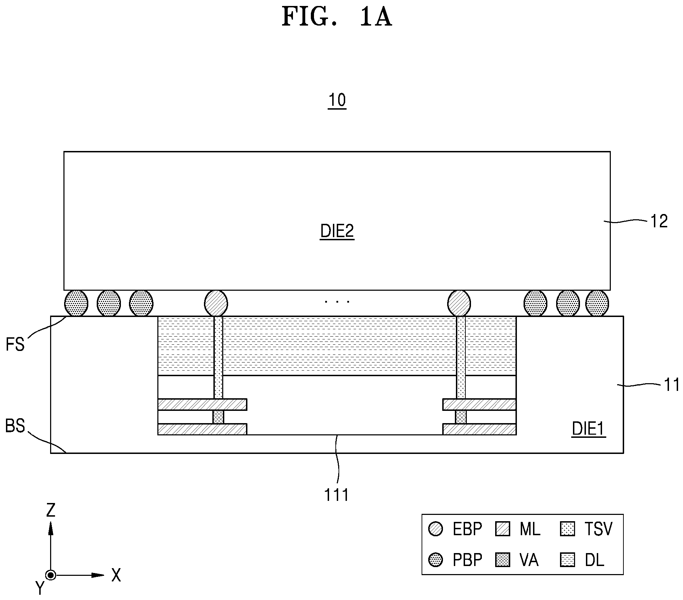

FIG. 1A shows a three-dimensional integrated circuit 10 according to an example embodiment.

Referring to FIG. 1A, the three-dimensional integrated circuit 10 may include a first die 11 and a second die 12 that are stacked in a vertical direction Z. The first die 11 may have a first surface (or first side FS) and a second surface (or second side BS) opposite each other, and the second die 12 may be vertically stacked on the first surface FS of the first die 11. Hereinafter, the first surface FS is referred to as a front side FS, and the second surface BS is referred to as a backside BS.

The three-dimensional integrated circuit 10 may be an integrated circuit device that achieves performance improvement and reduction in power/area compared to an existing two-dimensional process, by stacking and interconnecting a plurality of integrated circuits using vertical interconnections to operate as a single device. For example, the three-dimensional integrated circuit 10 may include an I-Cube package, which includes a logic circuit and high bandwidth memory (HBM) in one package, an X-Cube package, which includes a logic circuit and static random access memory (SRAM) in one package, or an HBM apparatus.

Herein, the term "three-dimensional integrated circuit (3D-IC)" may be used broadly to encompass various technologies, including a 2.5D integrated circuit (2.5D-IC), a three-dimensional stacking integrated circuit (3D-SIC), a three-dimensional heterogeneous integration circuit (3D-HI), a three-dimensional system on chip (3D-SOC), a three-dimensional system in package (3D-SIP), a three-dimensional wafer level package (3D-WLP), etc. Therefore, example embodiments of the three-dimensional integrated circuit described hereinafter may also be applied to the various integrated circuits and/or packages described above.

In some example embodiments, the first die 11 may be referred to as a lower die or a lower chip, and the second die 12 may be referred to as an upper die or an upper chip. The term "die" may be referred to as a chip, a substrate, a wafer, a semiconductor, etc., depending on example embodiments. The three-dimensional integrated circuit 10 may include a plurality of dies that are stacked in the vertical direction Z, and depending on example embodiments, the three-dimensional integrated circuit 10 may include three or more dies that are stacked in the vertical direction Z. In addition, the three-dimensional integrated circuit 10 may further include a third die that is adjacent to the first and second dies 11 and 12 in a first direction X or a second direction Y, and the first and second dies 11 and 12 and the third die may be stacked on a package substrate and/or an interposer and interconnected.

The first die 11 may include a functional block 111 (i.e., a functional circuit or functional block circuit) arranged on the front side FS of the first die 11. For example, the functional block 111 may include intellectual property (IP). For example, the IP may include circuitry to perform specific functions, and may have a design that includes a trade secret. In an example embodiment, the functional block 111 may include devices that form a circuit for processing a digital signal, such as memory and logic circuits. In an example embodiment, the functional block 111 may include devices that form a circuit for processing an analog signal, such as amplifiers. In an example embodiment, the functional block 111 may include at least one resistor. In an example embodiment, the functional block 111 may include devices that form a circuit for processing a mixed signal, such as analog-to-digital converters (ADCs) and temperature sensors. In an example embodiment, the functional block 111 may include at least one diode. In an example embodiment, the functional block 111 may include at least one capacitor. In an example embodiment, the functional block 111 may include devices for electrostatic discharge (ESD), such as diodes. In some example embodiments, the first die 11 may include a plurality of functional blocks, and the plurality of functional blocks may be designed independently of each other to each perform a unique function.

The first die 11 may include a plurality of conductive terminals arranged on the front side FS. The first die 11 and the second die 12 may be electrically connected to each other through the plurality of conductive terminals. The plurality of conductive terminals may refer to conductive materials arranged between the first die 11 and the second die 12. For example, the plurality of conductive terminals may be implemented as bumps, micro-bumps, or solder balls. For example, the first die 11 and the second die 12 may be electrically connected to each other by thermal compression bonding (TCB) of the plurality of conductive terminals. Herein, for convenience, the term "conductive terminal" is referred to as a "bump." However, it should be noted that the term "bump" used herein is intended to encompass any conductive material.

In detail, the plurality of conductive terminals may include: first bumps arranged on the functional block 111 and overlapping the functional block 111 in the vertical direction Z; and second bumps not overlapping the functional block 111 in the vertical direction Z. The first bumps may include a plurality of edge conductive terminals or a plurality of edge bumps EBP arranged on an edge region of the functional block 111. In an example embodiment, the first bumps are structures unrelated to functions of the functional block 111 and may be connected to an external device outside of the functional block 111. For example, the first bumps may be utilized to implement chip-level functions. The second bumps may include peripheral bumps PBP.

The peripheral bumps PBP may be spaced apart from each other by at least a minimum distance between bumps. Hereinafter, the expression "minimum distance between bumps" is referred to as a "bump minimum space." For example, the bump minimum space may be pre-defined by design rules. The plurality of edge bumps EBP may each be spaced apart from a boundary of the functional block 111 by a first distance that is greater than or equal to the bump minimum space. For example, the first distance may be pre-defined by 3D bump design rules.

As such, by arranging, on the functional block 111, the first bumps that are spaced apart from the boundary of the functional block 111 by a pre-defined distance, bump sweep between the second bumps may be prevented, and power and/or a signal may be smoothly transmitted between the first and second dies 11 and 12. For example, the signal may be transmitted with high integrity, and minimal signal loss and distortion. In addition, by arranging the first bumps, for example, the edge bumps EBP, that overlap the functional block 111, conductive bumps (instead of dummy bumps) may be arranged in a region adjacent to the functional block 111, and accordingly, power, performance, and area (PPA) of the three-dimensional integrated circuit 10 may be improved.

The functional block 111 may include: a device layer DL arranged on the front side FS of the first die 11; a metal layer or a wiring layer ML, which is arranged in the vertical direction Z with respect to the device layer DL; and a plurality of through-silicon vias (TSVs). A plurality of devices, for example, transistors, may be arranged in the device layer DL, and the plurality of edge bumps EBP may not be electrically connected to (i.e., may be electrically isolated from) the plurality of devices arranged in the device layer DL of the functional block 111. Depending on example embodiments, the device layer DL may be referred to as a logic region or an IP logic region.

The wiring layer ML may include a plurality of wiring patterns, and the plurality of wiring patterns may be electrically connected to an external device outside of the functional block 111. For example, the wiring layer ML may include a plurality of wiring layers that are spaced apart from each other in the vertical direction Z, and the plurality of wiring layers may be electrically connected to each other through vias VA. The plurality of TSVs may respectively be connected between the plurality of conductive terminals (for example, the plurality of edge bumps EBP) and the plurality of wiring patterns, and may each extend in the vertical direction Z. As such, a structure in which the device layer DL of the functional block 111 and the second die 12 face each other may be referred to as a face to back (F2B) structure, the first die 11 may be referred to as F2B IP, and the three-dimensional integrated circuit 10 may be referred to as an F2B chip.

According to an example embodiment, in an operation of designing the functional block 111, the first bumps (for example, the plurality of edge bumps EBP) and the plurality of TSVs may be pre-arranged based on the design of the functional block 111. For example, the functional block 111 may be designed before designing the three-dimensional integrated circuit 10. Thus, when designing the three-dimensional integrated circuit 10, the functional block 111 may be arranged. In this case, the first bumps (for example, the plurality of edge bumps EBP) and the plurality of TSVs may be pre-arranged at positions optimized for (i.e., in compliance with) 3D bump design rules, and thus, when designing the three-dimensional integrated circuit 10, the electrical characteristics of the functional block 111 may be prevented from being altered. In addition, by pre-designing the functional block 111 including the first bumps and/or the TSVs, the reliability of the conductive terminals may be improved, and when designing the three-dimensional integrated circuit 10, the functional block 111 may be re-used without additional verification or design revisions with respect to the functional block 111.

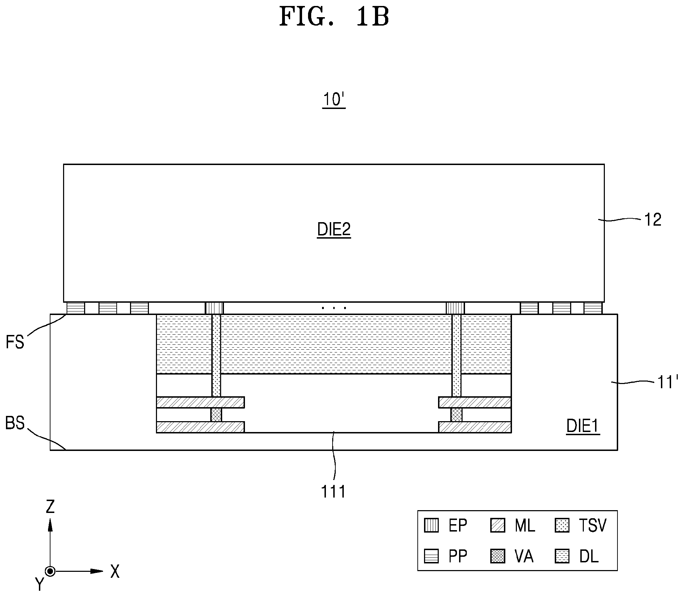

FIG. 1B shows a three-dimensional integrated circuit 10' according to an example embodiment.

Referring to FIG. 1B, the three-dimensional integrated circuit 10' may correspond to a modified example of the three-dimensional integrated circuit 10 of FIG. 1, and hereinafter, the differences from FIG. 1A are mainly described. The three-dimensional integrated circuit 10' may include a first die 11' and the second die 12 that are stacked in the vertical direction Z, and the first die 11' may include a plurality of conductive terminals arranged on the front side FS. The first die 11' and the second die 12 may be electrically connected to each other through the plurality of conductive terminals.

In the three-dimensional integrated circuit 10', the first die 11' and the second die 12 may be connected to each other by hybrid copper bonding (HCB). The plurality of conductive terminals may include conductive patterns, for example, copper patterns, and the first die 11' and the second die 12 may be electrically connected to each other through copper to copper (C2C) bonding. It should be noted that bump-related example embodiments described herein may also be equally applied to the HCB. Therefore, a method of arranging bumps described herein may also be equally applied to a method of arranging copper patterns by using HCB. In addition, a method of designing a functional block including bumps and TSVs described herein may also be equally applied to a method of designing a functional block including copper patterns by using HCB.

In detail, the plurality of conductive terminals may include: first conductive patterns arranged on the functional block 111 and overlapping the functional block 111 in the vertical direction Z; and second conductive patterns not overlapping the functional block 111 in the vertical direction Z. The first conductive patterns may include a plurality of edge conductive terminals or a plurality of edge patterns EP arranged on an edge region of the functional block 111. The second conductive patterns may include peripheral patterns PP.

The peripheral patterns PP may be spaced apart from each other by at least a minimum distance between the patterns. The plurality of edge patterns EP may each be spaced apart from a boundary of the functional block 111 by a first distance that is greater than or equal to the minimum distance between the patterns. As such, by arranging, on the functional block 111, the first conductive patterns that are spaced apart from the boundary of the functional block 111 by a pre-defined distance, power and/or a signal may be smoothly transmitted between the first and second dies 11' and 12. For example, the signal may be transmitted with high integrity, and minimal signal loss and distortion.

In addition, by arranging the first conductive patterns (for example, the edge patterns EP) that overlap the functional block 111, conductive patterns instead of dummy patterns may be arranged in a region adjacent to the functional block 111, and accordingly, PPA of the three-dimensional integrated circuit 10' may be improved. Furthermore, by designing the functional block 111 including the first conductive patterns, for example, the edge patterns EP, the reliability of the conductive patterns may be improved, and when designing the three-dimensional integrated circuit 10', the corresponding functional block may be re-used without additional verification with respect to the functional block 111.

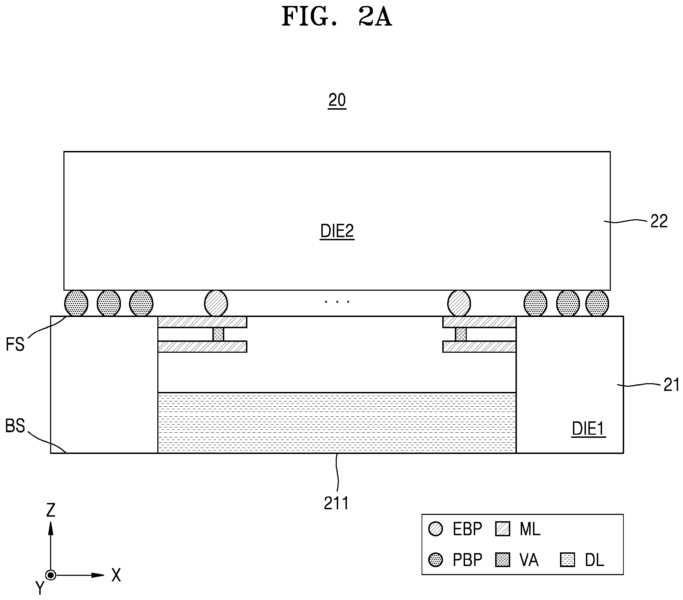

FIG. 2A shows a three-dimensional integrated circuit 20 according to an example embodiment.

Referring to FIG. 2A, the three-dimensional integrated circuit 20 may include a first die 21 and a second die 22 that are stacked in the vertical direction Z. The first die 21 may have the first surface FS and the second surface BS opposite each other, and the second die 22 may be vertically stacked on the first surface FS of the first die 21. Hereinafter, the first surface FS is referred to as the front side FS, and the second surface BS is referred to as the backside BS. The three-dimensional integrated circuit 20 corresponds a modified example of the three-dimensional integrated circuit 10 of FIG. 1A, and hereinafter, the differences from the three-dimensional integrated circuit 10 are mainly described.

The first die 21 may include a functional block 211 arranged on the backside BS of the first die 21. For example, the functional block 211 may include IP. In an example embodiment, the functional block 111 may include devices that form a circuit for processing a digital signal, such as memory and logic circuits. In addition, the first die 21 may include a plurality of conductive terminals arranged on the front side FS. The first die 21 and the second die 22 may be electrically connected to each other through the plurality of conductive terminals. For example, the plurality of conductive terminals may be implemented as bumps, micro-bumps, or solder balls.

In detail, the plurality of conductive terminals may include: first bumps arranged on the front side FS to overlap the functional block 211 in the vertical direction Z; and second bumps not overlapping the functional block 211 in the vertical direction Z. The first bumps may include a plurality of edge conductive terminals or a plurality of edge bumps EBP that overlap an edge region of the functional block 211. In an example embodiment, the first bumps are structures unrelated to functions of the functional block 211 and may be connected to an external device outside of the functional block 211. The second bumps may include peripheral bumps PBP.

The peripheral bumps PBP may be spaced apart from each other by at least the bump minimum space. The plurality of edge bumps EBP may each be spaced apart from a boundary of the functional block 211 by a first distance that is greater than or equal to the bump minimum space. For example, the bump minimum space may be pre-defined by design rules. For example, the first distance may be pre-defined by 3D bump design rules.

As such, by arranging, on the functional block 211, the first bumps that are spaced apart from the boundary of the functional block 211 by a pre-defined distance, bump sweep between the second bumps may be prevented, and power and/or a signal may be smoothly transmitted between the first and second dies 21 and 22. For example, the signal may be transmitted with high integrity, and minimal signal loss and distortion. In addition, by arranging the first bumps (for example, the edge bumps EBP) that overlap the functional block 211, conductive bumps (instead of dummy bumps) may be arranged in a region adjacent to the functional block 211, and accordingly, PPA of the three-dimensional integrated circuit 20 may be improved.

The functional block 211 may include: the device layer DL arranged on the backside BS of the first die 11; and a metal layer or the wiring layer ML, which is arranged in the vertical direction Z with respect to the device layer DL. A plurality of devices, for example, transistors, may be arranged in the device layer DL, and the plurality of edge bumps EBP may not be electrically connected to (i.e., may be electrically isolated from) the plurality of devices arranged in the device layer DL of the functional block 211. Depending on example embodiments, the device layer DL may be referred to as a logic region or an IP logic region.

The wiring layer ML may include a plurality of wiring patterns, and the plurality of wiring patterns may be electrically connected to an external device outside of the functional block 211. For example, the wiring layer ML may include a plurality of wiring layers that are spaced apart from each other in the vertical direction Z, and the plurality of wiring layers may be electrically connected to each other through vias VA. As such, a structure in which the wiring layer ML of the functional block 211 and the second die 22 face each other may be referred to as a face to face (F2F) structure, the first die 21 may be referred to as F2F IP, and the three-dimensional integrated circuit 20 may be referred to as an F2F chip.

According to an example embodiment, in an operation of designing the functional block 211, the first bumps (for example, the plurality of edge bumps EBP) and a plurality of TSVs may be pre-arranged based on the design of the functional block 211. For example, the functional block 211 may be designed before designing the three-dimensional integrated circuit 20. Thus, when designing the three-dimensional integrated circuit 20, the functional block 211 may be arranged. In this case, the first bumps (for example, the plurality of edge bumps EBP) and the plurality of TSVs may be pre-arranged at positions optimized for (i.e., in compliance with) 3D bump design rules, and thus, when designing the three-dimensional integrated circuit 20, the electrical characteristics of the functional block 211 may be prevented from being altered. In addition, by pre-designing the functional block 211 including the first bumps and/or the TSVs, the reliability of the conductive terminals may be improved, and when designing the three-dimensional integrated circuit 20, the functional block 211 may be re-used without additional verification or design revisions with respect to the functional block 211.

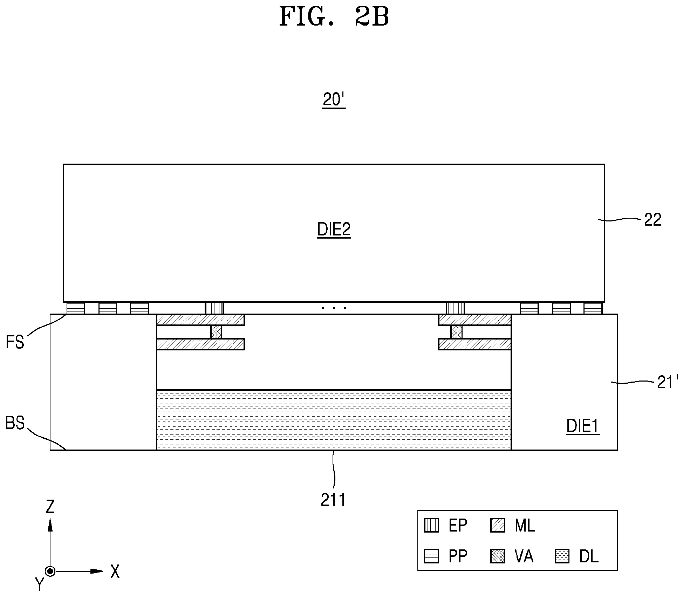

FIG. 2B shows a three-dimensional integrated circuit 20' according to an example embodiment.

Referring to FIG. 2B, the three-dimensional integrated circuit 20' may correspond to a modified example of the three-dimensional integrated circuit 20 of FIG. 2A, and hereinafter, the differences from FIG. 2A are mainly described. The three-dimensional integrated circuit 20' may include a first die 21' and the second die 22 that are stacked in the vertical direction Z, and the first die 21' may include a plurality of conductive terminals arranged on the front side FS. The first die 21' and the second die 22 may be electrically connected to each other through the plurality of conductive terminals.

According to an example embodiment, the first die 21' and the second die 22 may be connected to each other by HCB. The plurality of conductive terminals may include conductive patterns, for example, copper patterns, and the first die 21' and the second die 22 may be electrically connected to each other through C2C bonding. It should be noted that bump-related example embodiments described herein may also be equally applied to the HCB.

In detail, the plurality of conductive terminals may include: first conductive patterns overlapping the functional block 211 in the vertical direction Z; and second conductive patterns not overlapping the functional block 211 in the vertical direction Z. The first conductive patterns may include a plurality of edge conductive terminals or a plurality of edge patterns EP that overlap an edge region of the functional block 211. The second conductive patterns may include peripheral patterns PP.

The peripheral patterns PP may be spaced apart from each other by at least a minimum distance between the patterns. The plurality of edge patterns EP may each be spaced apart from a boundary of the functional block 211 by a first distance that is greater than or equal to the minimum distance between the patterns. As such, by arranging, on the functional block 211, the first conductive patterns that are spaced apart from the boundary of the functional block 211 by a pre-defined distance, power and/or a signal may be smoothly transmitted between the first and second dies 21' and 22. For example, the signal may be transmitted with high integrity, and minimal signal loss and distortion.

In addition, by arranging the first conductive patterns (for example, the edge patterns EP) that overlap the functional block 211, conductive patterns instead of dummy patterns may be arranged in a region adjacent to the functional block 211, and accordingly, PPA of the three-dimensional integrated circuit 20' may be improved. Furthermore, by designing the functional block 211 including the first conductive patterns, for example, the edge patterns EP, the reliability of the conductive patterns may be improved, and when designing the three-dimensional integrated circuit 20', the corresponding functional block may be re-used without additional verification with respect to the functional block 211.

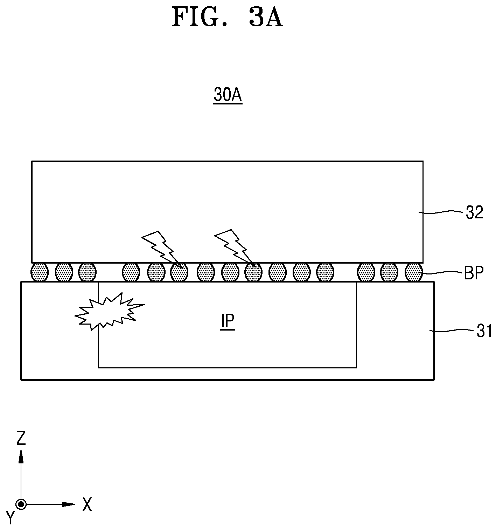

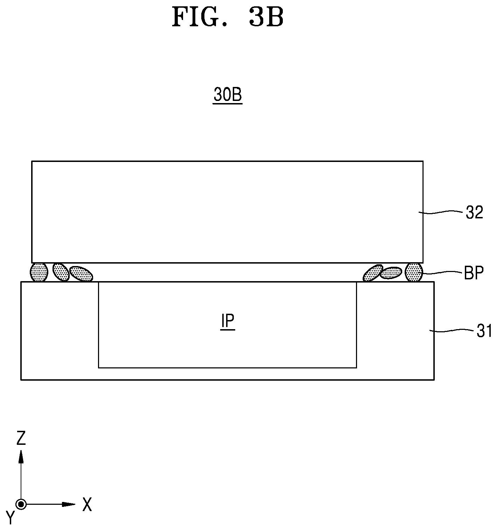

FIGS. 3A and 3B each show a three-dimensional integrated circuit according to comparative examples.

Referring to FIG. 3A, a three-dimensional integrated circuit 30A includes a first die 31 and a second die 32 that are connected to each other through a plurality of bumps BP. The three-dimensional integrated circuit 30A may include bumps BP arranged on a functional block IP in the same manner as bumps BP arranged on a region offset from the functional block IP. In this case, the electrical characteristics of the functional block IP may be altered due to the bumps BP, or ESD issues may arise from the bumps BP. Therefore, unlike two-dimensional integrated circuits, in the case of three-dimensional integrated circuits, there arises an issue where the functional block IP needs to be re-verified after stacking and interconnecting the first and second dies 31 and 32.

Referring to FIG. 3B, in order to address the above issue regarding the three-dimensional integrated circuit 30A, in the case of a three-dimensional integrated circuit 30B, the bumps BP may not be arranged on the functional block IP. In this case, when the size of the functional block IP increases, an empty space between the first die 31 and the second die 32 becomes larger, and this empty space may result in bump sweep. The bump sweep may refer to a phenomenon where some bumps among the bumps BP arranged in a region other than the functional block IP topple, thereby causing a short circuit between adjacent bumps, or causing some bumps to be disconnected. Due to this bump sweep, the reliability of the three-dimensional integrated circuit 30B may be reduced.

However, as described above with reference to FIGS. 1A to 2B, the three-dimensional integrated circuit 10, 10', 20, or 20' may include the first bumps or the first conductive patterns that overlap the functional block 111 or 211 in the vertical direction Z, and the first bumps or the first conductive patterns may be spaced apart from an edge of the functional block 111 or 211 by a certain distance. In this case, the certain distance may be at least a minimum distance between the second bumps or the second conductive patterns arranged on a region other than the functional block 111 or 211. Accordingly, bump sweep may be prevented in the second bumps or the second conductive patterns arranged on the region other than the functional block 111 or 211, and thus, the reliability of the three-dimensional integrated circuit 10, 10', 20, or 20' may be improved. In addition, by arranging the first bumps or the first conductive patterns on the functional block 111 or 211, power and/or a signal may be smoothly transmitted between the first and second dies. For example, the signal may be transmitted with high integrity, and minimal signal loss and distortion. Accordingly, the performance of the three-dimensional integrated circuit 10, 10', 20, or 20' may be improved.

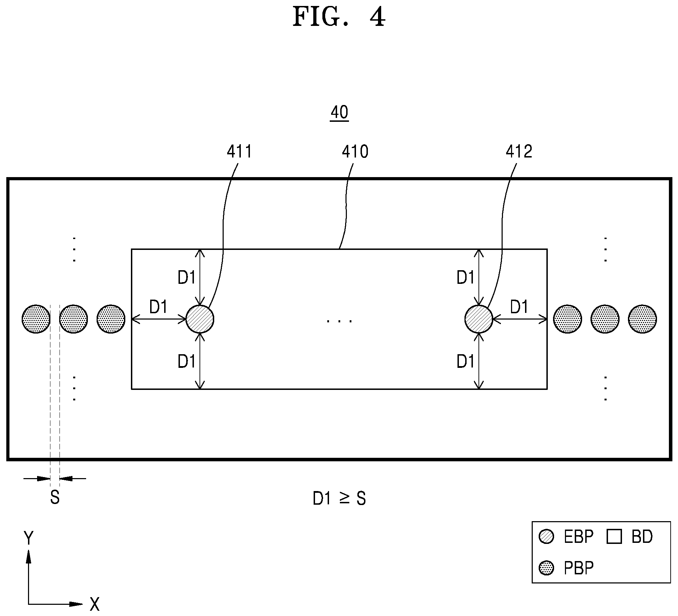

FIG. 4 is a plan view showing a die 40 according to an example embodiment.

Referring to FIG. 4, the die 40 may correspond to an example of the first die 11, 11', 21, or 21' of FIGS. 1A to 2B. The die 40 may include a functional block 410, and the functional block 410 may correspond to an example of the functional block 111 or 211 of FIGS. 1A to 2B. The die 40 may further include a plurality of conductive terminals arranged on a first surface, for example, the front side FS. The plurality of conductive terminals may include a plurality of edge bumps EBP overlapping the functional block 410 and a plurality of peripheral bumps PBP not overlapping the functional block 410.

Adjacent peripheral bumps PBP among the plurality of peripheral bumps PBP may be spaced apart from each other by a bump minimum space S. In an example embodiment, the adjacent peripheral bumps PBP may be spaced apart from each other by a distance that is greater than the bump minimum space S. In an example embodiment, a distance between peripheral bumps PBP that are adjacent to each other in the first direction X may be equal to a distance between peripheral bumps PBP that are adjacent to each other in the second direction Y. In an example embodiment, a distance between peripheral bumps PBP that are adjacent to each other in the first direction X may be different from a distance between peripheral bumps PBP that are adjacent to each other in the second direction Y. In an example embodiment, distances between the plurality of peripheral bumps PBP may be different from each other.

The plurality of edge bumps EBP may each be spaced apart from a boundary BD of the functional block 410 by a first distance D1. For example, the plurality of edge bumps EBP may include a first edge bump 411 and a second edge bump 412. The first edge bump 411 may be spaced apart from the boundary BD of the functional block 410 by the first distance D1, and the second edge bump 412 may be spaced apart from the boundary BD of the functional block 410 by the first distance D1. In this case, the first distance D1 may be greater than or equal to the bump minimum space S.

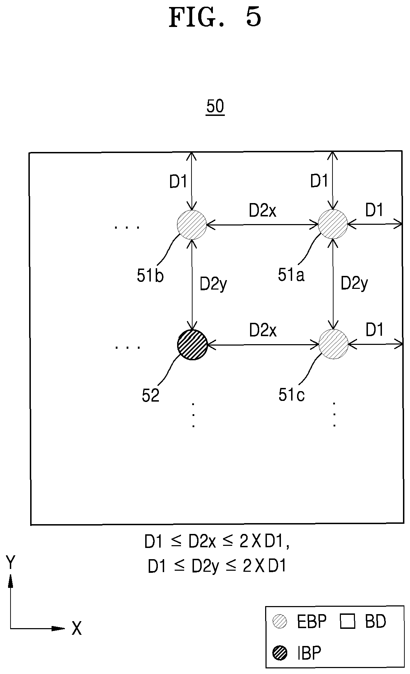

FIG. 5 is a plan view showing a functional block 50 according to an example embodiment.

Referring to FIG. 5, the functional block 50 may correspond to an example of the functional block 111 or 211 of FIGS. 1A to 2B. A plurality of conductive terminals may be arranged above the functional block 50. For example, the plurality of conductive terminals may include edge bumps EBP arranged in an edge region of the functional block 50 and internal bumps IBP arranged in a central region or inner region of the functional block 50. The edge bumps EBP may include first to third edge bumps 51a to 51c that are each spaced apart from the boundary BD of the functional block 50 by the first distance D1. The internal bumps IBP may include a first internal bump 52.

The first and second edge bumps 51a and 51b may be spaced apart from each other by a second distance D2x that is greater than or equal to the first distance D1 in the first direction X. The first and third edge bumps 51a and 51c may be spaced apart from each other by a second distance D2y that is greater than or equal to the first distance D1 in the second direction Y. The first internal bump 52 may be spaced apart from the second edge bump 51b in the second direction Y by the second distance D2y, and may be spaced apart from the third edge bump 51c in the first direction X by the second distance D2x. In this case, the second distance D2x may correspond to a value between the first distance D1 and twice the first distance 2*D1 (that is, ranging from the first distance D1 to twice the first distance 2*D1), and the second distance D2y may correspond to a value between the first distance D1 and twice the first distance 2*D1. In an example embodiment, the second distances D2x and D2y may be equal to each other. In an example embodiment, the second distances D2x and D2y may be different from each other.

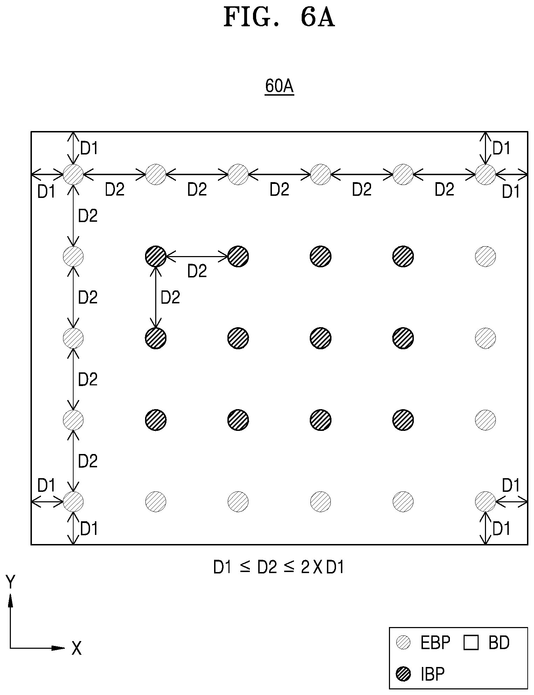

FIG. 6A is a plan view showing a functional block 60A according to an example embodiment.

Referring to FIG. 6A, the functional block 60A may correspond to an example of the functional block 111 or 211 of FIGS. 1A to 2B. A plurality of conductive terminals may be arranged above the functional block 60A. The plurality of conductive terminals may include edge bumps EBP arranged in an edge region of the functional block 60A and internal bumps IBP arranged in a central region or inner region of the functional block 60A. The edge bumps EBP may each be spaced apart from the boundary BD of the functional block 60A by the first distance D1.

Edge bumps EBP that are adjacent to each other in the first direction X may be spaced apart from each other by a second distance D2, and edge bumps EBP that are adjacent to each other in the second direction Y may be spaced apart from each other by the second distance D2. The internal bumps IBP may be spaced apart from each other by the second distance D2 in the first direction X and the second direction Y. For example, the first distance D1 may be greater than or equal to the bump minimum space (for example, S of FIG. 4). For example, the second distance D2 may correspond to a value between the first distance D1 and twice the first distance 2*D1.

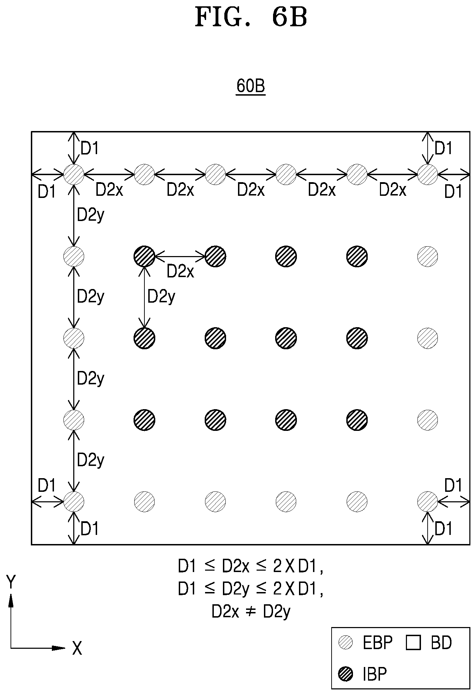

FIG. 6B is a plan view showing a functional block 60B according to an example embodiment.

Referring to FIG. 6B, the functional block 60B may correspond to an example of the functional block 111 or 211 of FIGS. 1A to 2B, and may correspond to a modified example of the functional block 60A of FIG. 6A. The edge bumps EBP may each be spaced apart from the boundary BD of the functional block 60B by the first distance D1. Edge bumps EBP that are adjacent to each other in the first direction X may be spaced apart from each other by the second distance D2x, and edge bumps EBP that are adjacent to each other in the second direction Y may be spaced apart from each other by the second distance D2y.

Internal bumps IBP that are adjacent to each other in the first direction X may be spaced apart from each other by the second distance D2x, and internal bumps IBP that are adjacent to each other in the second direction Y may be spaced apart from each other by the second distance D2y. For example, the first distance D1 may be greater than or equal to the bump minimum space (for example, S of FIG. 4). For example, the second distance D2x may correspond to a value between the first distance D1 and twice the first distance 2*D1. For example, the second distance D2y may correspond to a value between the first distance D1 and twice the first distance 2*D1. In this case, the second distances D2x and D2y may be different from each other.

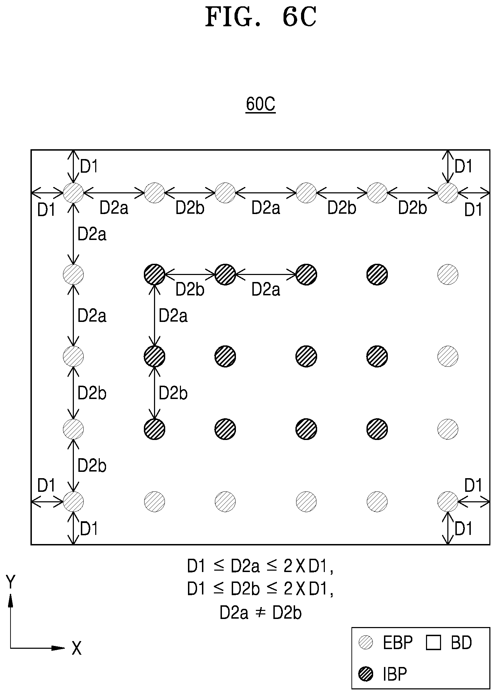

FIG. 6C is a plan view showing a functional block 60C according to an example embodiment.

Referring to FIG. 6C, the functional block 60C may correspond to an example of the functional block 111 or 211 of FIGS. 1A to 2B, and may correspond to a modified example of the functional block 60A of FIG. 6A. The edge bumps EBP may each be spaced apart from the boundary BD of the functional block 60C by the first distance D1. Edge bumps EBP that are adjacent to each other in the first direction X may include edge bumps EBP that are spaced apart from each other by a second distance D2a and edge bumps EBP that are spaced apart from each other by a second distance D2b. Edge bumps EBP that are adjacent to each other in the second direction Y may include edge bumps EBP that are spaced apart from each other by the second distance D2a and edge bumps EBP that are spaced apart from each other by the second distance D2b.

Internal bumps IBP that are adjacent to each other in the first direction X may include internal bumps IBP that are spaced apart from each other by the second distance D2a and internal bumps IBP that are spaced apart from each other by the second distance D2b. Internal bumps IBP that are adjacent to each other in the second direction Y may include internal bumps IBP that are spaced apart from each other by the second distance D2a and internal bumps IBP that are spaced apart from each other by the second distance D2b. For example, the first distance D1 may be greater than or equal to the bump minimum space (for example, S of FIG. 4). For example, the second distance D2a may correspond to a value between the first distance D1 and twice the first distance 2*D1. For example, the second distance D2b may correspond to a value between the first distance D1 and twice the first distance 2*D1. In this case, the second distances D2a and D2b may be different from each other.

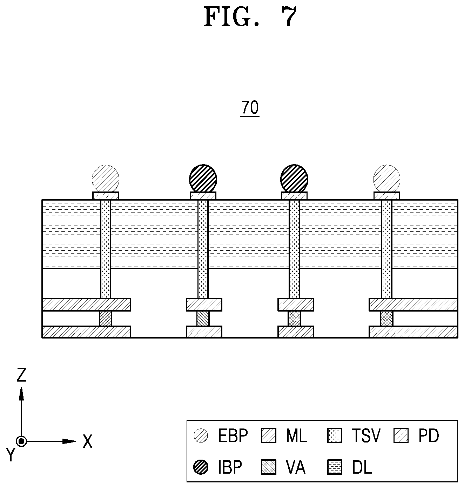

FIG. 7 is a cross-sectional view of a functional block 70 according to an example embodiment.

Referring to FIG. 7, the functional block 70 may include: the device layer DL and the wiring layer ML that are spaced apart from each other in the vertical direction Z; and a plurality of TSVs TSV each extending in the vertical direction Z. For example, the functional block 70 may correspond to F2B IP. A plurality of devices, for example, transistors, may be arranged in the device layer DL. The wiring layer ML may include a plurality of wiring patterns, and the plurality of wiring patterns may be electrically connected to an external device outside of the functional block 70. For example, the wiring layer ML may include a plurality of wiring layers that are spaced apart from each other in the vertical direction Z, and the plurality of wiring layers may be electrically connected to each other through vias VA.

A plurality of pads PD may be arranged on the functional block 70, and a plurality of conductive terminals may be arranged on the plurality of pads PD, respectively. The plurality of TSVs TSV may respectively be connected between the plurality of pads PD and the plurality of wiring patterns, and may each extend in the vertical direction Z. The plurality of conductive terminals may include a plurality of edge bumps EBP and a plurality of internal bumps IBP. The plurality of edge bumps EBP and the plurality of internal bumps IBP may respectively be connected to the plurality of wiring patterns through the plurality of pads PD and the plurality of TSVs TSV. As such, the plurality of conductive terminals may be spaced apart from the wiring layer ML in the vertical direction Z, and may be arranged on the device layer DL.

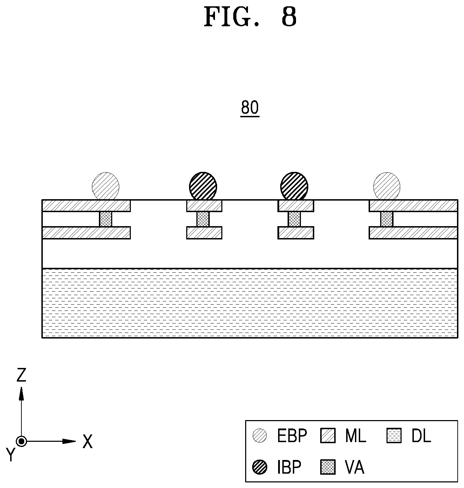

FIG. 8 is a cross-sectional view of a functional block 80 according to an example embodiment.

Referring to FIG. 8, the functional block 80 may include the device layer DL and the wiring layer ML that are spaced apart from each other in the vertical direction Z. For example, the functional block 80 may correspond to F2F IP. A plurality of devices, for example, transistors, may be arranged in the device layer DL. The wiring layer ML may include a plurality of wiring patterns, and the plurality of wiring patterns may be electrically connected to an external device outside of the functional block 80. For example, the wiring layer ML may include a plurality of wiring layers that are spaced apart from each other in the vertical direction Z, and the plurality of wiring layers may be electrically connected to each other through vias VA.

A plurality of conductive terminals may be arranged on the functional block 80. The plurality of conductive terminals may include a plurality of edge bumps EBP and a plurality of internal bumps IBP, and the plurality of edge bumps EBP and the plurality of internal bumps IBP may respectively be connected to the plurality of wiring patterns. As such, the plurality of conductive terminals may be spaced apart from the device layer DL in the vertical direction Z, and may be arranged on the wiring layer ML.

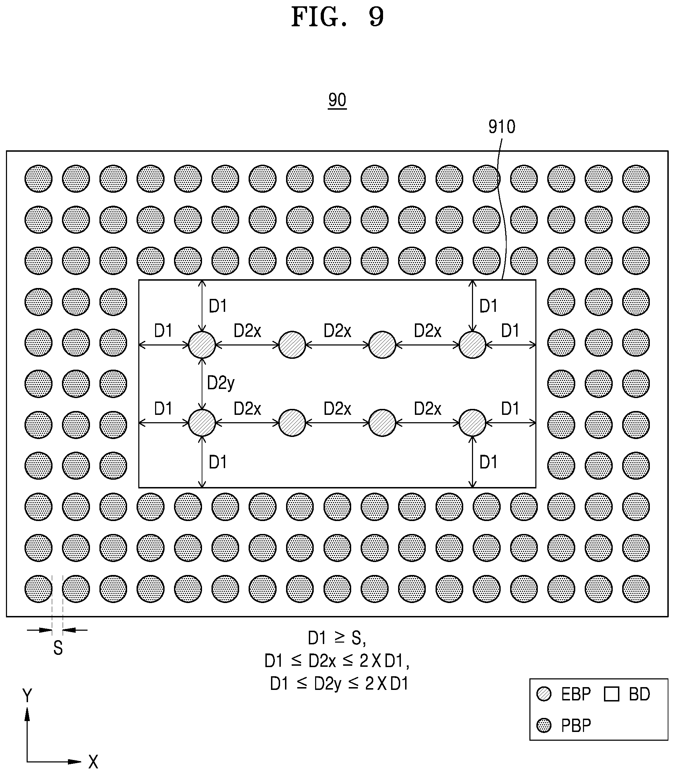

FIG. 9 is a plan view showing a die 90 according to an example embodiment.

Referring to FIG. 9, the die 90 may correspond to an example of the first die 11, 11', 21, or 21' of FIGS. 1A to 2B. The die 90 may include a functional block 910, and the functional block 910 may correspond to an example of the functional block 111 or 211 of FIGS. 1A to 2B. The die 90 may further include a plurality of conductive terminals arranged on a first surface, for example, the front side FS. The plurality of conductive terminals may include a plurality of edge bumps EBP overlapping the functional block 910 and a plurality of peripheral bumps PBP not overlapping the functional block 910.

Adjacent peripheral bumps PBP among the plurality of peripheral bumps PBP may be spaced apart from each other by the bump minimum space S. In an example embodiment, the adjacent peripheral bumps PBP may be spaced apart from each other by a distance that is greater than the bump minimum space S. In an example embodiment, a distance between peripheral bumps PBP that are adjacent to each other in the first direction X may be equal to a distance between peripheral bumps PBP that are adjacent to each other in the second direction Y. In an example embodiment, a distance between peripheral bumps PBP that are adjacent to each other in the first direction X may be different from a distance between peripheral bumps PBP that are adjacent to each other in the second direction Y. In an example embodiment, distances between the plurality of peripheral bumps PBP may be different from each other.

The plurality of edge bumps EBP may each be spaced apart from the boundary BD of the functional block 910 by the first distance D1. The first distance D1 may be greater than or equal to the bump minimum space S. Edge bumps EBP that are adjacent to each other in the first direction X may be spaced apart from each other by the second distance D2x, and edge bumps EBP that are adjacent to each other in the second direction Y may be spaced apart from each other by the second distance D2y. The second distance D2x may correspond to a value between the first distance D1 and twice the first distance 2*D1, and the second distance D2y may correspond to a value between the first distance D1 and twice the first distance 2*D1.

When the edge bumps EBP overlapping the functional block 910 are not arranged, in order to prevent bump sweep, a plurality of dummy bumps may need to be arranged above an external region adjacent to the functional block 910. In this case, by arranging the plurality of dummy bumps, the number of peripheral bumps PBP may be further reduced, and thus, it may be difficult to smoothly transmit power and/or a signal between dies stacked in a three-dimensional integrated circuit.

However, according to an example embodiment, by arranging the plurality of edge bumps EBP overlapping the functional block 910, the plurality of peripheral bumps PBP instead of a plurality of dummy bumps may be arranged above an external region adjacent to the functional block 910. Accordingly, through the plurality of edge bumps EBP and the plurality of peripheral bumps PBP, power and/or a signal may be smoothly transmitted between dies stacked in a three-dimensional integrated circuit. For example, the signal may be transmitted with high integrity, and minimal signal loss and distortion.

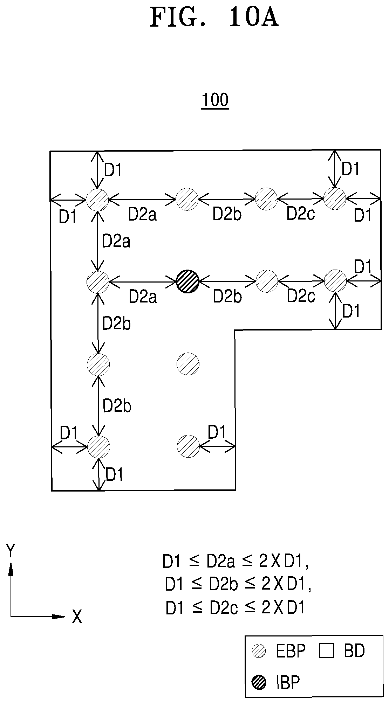

FIG. 10A shows a functional block 100 according to an example embodiment.

Referring to FIG. 10A, the functional block 100 may include a plurality of edge bumps EBP and an internal bump IBP. The plurality of edge bumps EBP may each be spaced apart from the boundary BD of the functional block 100 by the first distance D1 that is greater than or equal to the bump minimum space. For example, edge bumps EBP that are adjacent to each other in the first direction X may include edge bumps EBP that are spaced apart from each other by the second distance D2a, edge bumps EBP that are spaced apart from each other by the second distance D2b, and edge bumps EBP that are spaced apart from each other by a second distance D2c. For example, edge bumps EBP that are adjacent to each other in the second direction Y may include edge bumps EBP that are spaced apart from each other by the second distance D2a and edge bumps EBP that are spaced apart from each other by the second distance D2b. The internal bump IBP may be spaced apart from a left edge bump EBP by the second distance D2a and may be spaced apart from a right edge bump EBP by the second distance D2b.

For example, the second distance D2a may correspond to a value between the first distance D1 and twice the first distance 2*D1. For example, the second distance D2b may correspond to a value between the first distance D1 and twice the first distance 2*D1. For example, the second distance D2c may correspond to a value between the first distance D1 and twice the first distance 2*D1. In an example embodiment, the second distances D2a, D2b, and D2c may be equal to each other. In an example embodiment, the second distances D2a, D2b, and D2c may be different from each other.

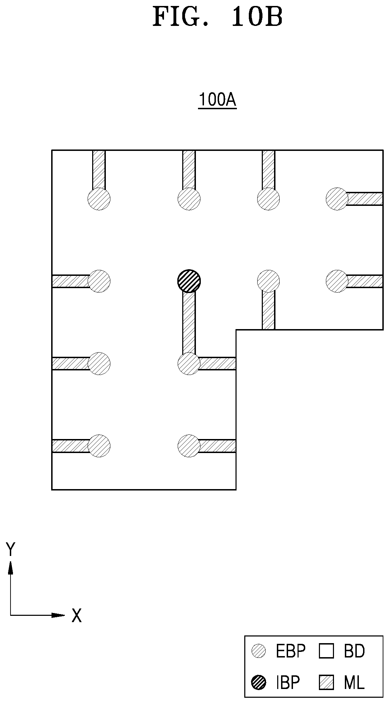

FIG. 10B shows a functional block 100A according to an example embodiment.

Referring to FIG. 10B, the functional block 100A may correspond to a modified example of the functional block 100 of FIG. 10A. The functional block 100A may include the wiring layer ML including a plurality of wiring patterns. The edge bumps EBP and the internal bump IBP on the functional block 100A may be electrically connected to the plurality of wiring patterns. In an example embodiment, the wiring layer ML may correspond to an uppermost metal layer, and the edge bumps EBP and the internal bump IBP may be directly connected to the plurality of wiring patterns. In an example embodiment, the edge bumps EBP and the internal bump IBP may be connected to the plurality of wiring patterns through a plurality of TSVs. The edge bumps EBP and the internal bump IBP may be electrically connected to an external device outside of the functional block 100A through the plurality of wiring patterns.

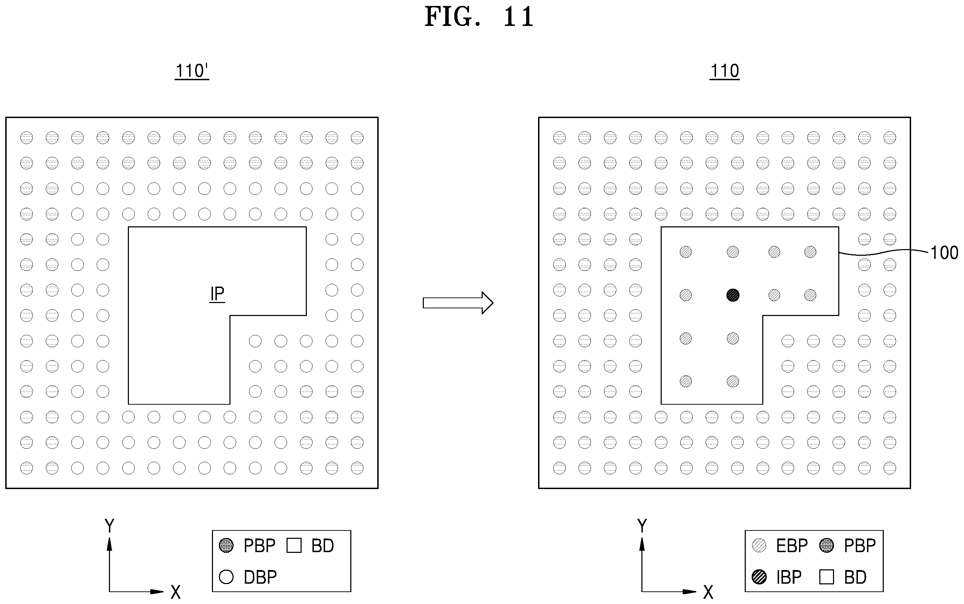

FIG. 11 is a plan view showing a die 110' according to a comparative example and a die 110 according to an example embodiment.

Referring to FIG. 11, when bumps are not arranged on the functional block IP of the die 110', dummy bumps DBP may be arranged in an external region that is close to the functional block IP, and peripheral bumps PBP may be arranged in an external region that is far from the functional block IP (i.e., is separated from the functional block IP by the dummy bumps DBP). When the number of dummy bumps DBP increases, the number of peripheral bumps PBP decreases, and thus, the performance of a three-dimensional integrated circuit including the die 110' may deteriorate.

However, the die 110 according to an example embodiment may include edge bumps EBP and internal bumps IBP that are arranged at certain intervals on the functional block 100, and may transmit power and/or a signal to an upper die or a lower die that is stacked on the die 110 through the edge bumps EBP and the internal bumps IBP. In this case, the functional block 100 may correspond to the functional block 100 of FIG. 10A. In addition, because peripheral bumps PBP instead of dummy bumps may be arranged in external regions that are close to the functional block 100, the number of peripheral bumps PBP may be sufficiently secured, and power and/or a signal may be transmitted to the upper die or the lower die that is stacked on the die 110 through the peripheral bumps PBP. Therefore, the performance of a three-dimensional integrated circuit including the die 110 may be improved.

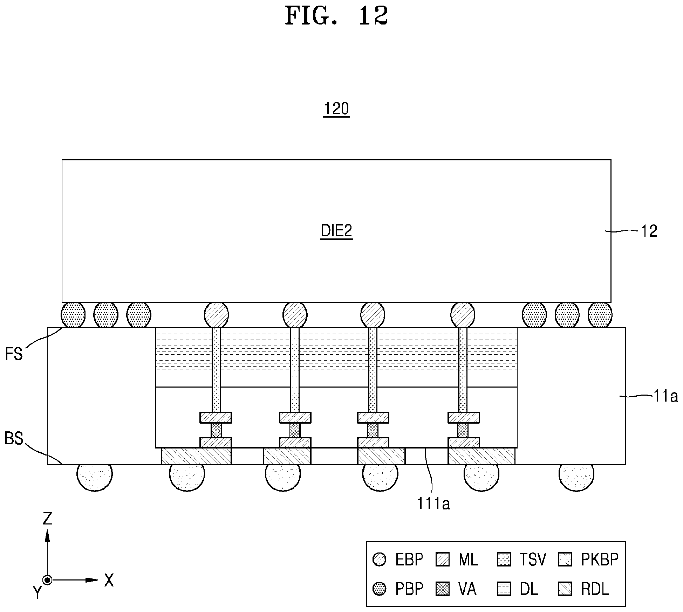

FIG. 12 shows a three-dimensional integrated circuit 120 according to an example embodiment.

Referring to FIG. 12, the three-dimensional integrated circuit 120 may correspond to a modified example of the three-dimensional integrated circuit 10 of FIG. 1A. The three-dimensional integrated circuit 120 may include a first die 11a and the second die 12 that are stacked in the vertical direction Z, and the first die 11a may include a functional block 111a. The functional block 111a may correspond to a modified example of the functional block 111 of FIG. 1A. The first die 11a may have the front side FS and the backside BS opposite each other. A plurality of conductive terminals including edge bumps EBP and peripheral bumps PBP may be arranged on the front side FS of the first die 11a, and the first die 11a may be electrically connected to the second die 12 through the plurality of conductive terminals. Package bumps PKBP may be arranged on the backside BS of the first die 11a, and the first die 11a may be electrically connected to a package substrate through the package bumps PKBP.

The first die 11a may include the functional block 111a arranged on the front side FS and a redistribution layer RDL arranged on the backside BS. The wiring layer ML of the functional block 111a may be electrically connected to the redistribution layer RDL, and the redistribution layer RDL may be electrically connected to the package bumps PKBP. In an example embodiment, power and/or a signal received through the package bumps PKBP may be transmitted to the second die 12 through the redistribution layer RDL, the wiring layer ML, vias VA, TSVs TSV, and the edge bumps EBP. In an example embodiment, a signal generated in the second die 12 may be transmitted to the outside of the three-dimensional integrated circuit 120 through the edge bumps EBP, the TSVs TSV, the vias VA, the wiring layer ML, the redistribution layer RDL, and the package bumps PKBP.

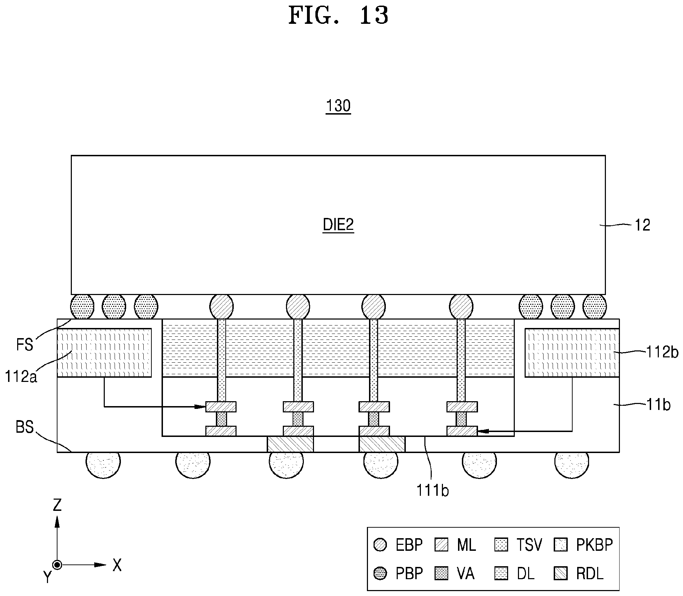

FIG. 13 shows a three-dimensional integrated circuit 130 according to an example embodiment.

Referring to FIG. 13, the three-dimensional integrated circuit 130 may correspond to a modified example of the three-dimensional integrated circuit 10 of FIG. 1A. The three-dimensional integrated circuit 130 may include a first die 11b and the second die 12 that are stacked in the vertical direction Z, and the first die 11b may include a functional block 111b and a plurality of devices 112a and 112b. The functional block 111b may correspond to a modified example of the functional block 111 of FIG. 1A. The first die 11b may have the front side FS and the backside BS opposite each other. A plurality of conductive terminals including edge bumps EBP and peripheral bumps PBP may be arranged on the front side FS of the first die 11b, and the first die 11b may be electrically connected to the second die 12 through the plurality of conductive terminals. Package bumps PKBP may be arranged on the backside BS of the first die 11b, and the first die 11b may be electrically connected to a package substrate through the package bumps PKBP.

The first die 11b may include the functional block 111b arranged on the front side FS, the redistribution layer RDL arranged on the backside BS, and the plurality of devices 112a and 112b. Some wiring patterns included in the wiring layer ML of the functional block 111b may be electrically connected to the redistribution layer RDL, and the redistribution layer RDL may be electrically connected to the package bumps PKBP. In addition, some wiring patterns included in the wiring layer ML of the functional block 111b may respectively be connected to the plurality of devices 112a and 112b.

In an example embodiment, power and/or a signal received through the plurality of devices 112a and 112b may be transmitted to the second die 12 through the wiring layer ML, vias VA, TSVs TSV, and the edge bumps EBP. In an example embodiment, power and/or a signal received through the package bumps PKBP may be transmitted to the second die 12 through the redistribution layer RDL, the wiring layer ML, the vias VA, the TSVs TSV, and the edge bumps EBP. In an example embodiment, a first signal among signals generated in the second die 12 may be transmitted to the plurality of devices 112a and 112b through the edge bumps EBP, the TSVs TSV, the vias VA, and the wiring layer ML. In an example embodiment, a second signal among the signals generated in the second die 12 may be transmitted to the outside of the three-dimensional integrated circuit 130 through the edge bumps EBP, the TSVs TSV, the vias VA, the wiring layer ML, the redistribution layer RDL, and the package bumps PKBP.

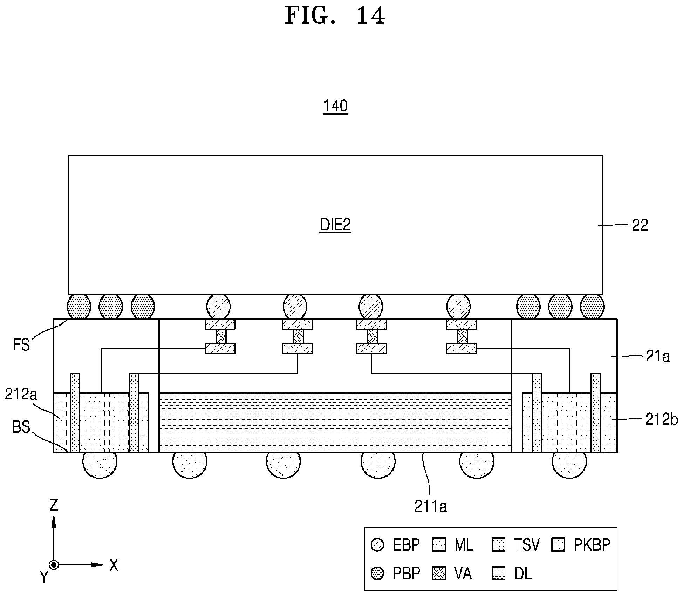

FIG. 14 shows a three-dimensional integrated circuit 140 according to an example embodiment.

Referring to FIG. 14, the three-dimensional integrated circuit 140 may correspond to a modified example of the three-dimensional integrated circuit 20 of FIG. 2A. The three-dimensional integrated circuit 140 may include a first die 21a and the second die 22 that are stacked in the vertical direction Z, and the first die 21a may include a functional block 211a and a plurality of devices 212a and 212b. The functional block 211a may correspond to a modified example of the functional block 211 of FIG. 2A. The first die 21a may have the front side FS and the backside BS opposite each other. A plurality of conductive terminals including edge bumps EBP and peripheral bumps PBP may be arranged on the front side FS of the first die 21a, and the first die 21a may be electrically connected to the second die 22 through the plurality of conductive terminals. Package bumps PKBP may be arranged on the backside BS of the first die 21a, and the first die 21a may be electrically connected to a package substrate through the package bumps PKBP.

The first die 21a may include, arranged on the backside BS, the functional block 211a and the plurality of devices 212a and 212b. Wiring patterns included in the wiring layer ML of the functional block 211a may be electrically connected to the plurality of devices 212a and 212b or TSVs TSV outside the functional block 211a. In an example embodiment, power and/or a signal received through the plurality of devices 212a and 212b may be transmitted to the second die 22 through the TSVs TSV, the wiring layer ML, vias VA, and the edge bumps EBP. In an example embodiment, power and/or a signal received through the package bumps PKBP may be transmitted to the second die 22 through the plurality of devices 212a and 212b, the wiring layer ML, the vias VA, and the edge bumps EBP. In an example embodiment, a first signal among signals generated in the second die 22 may be transmitted to the plurality of devices 212a and 212b through the edge bumps EBP, the vias VA, and the wiring layer ML. In an example embodiment, a second signal among the signals generated in the second die 22 may be transmitted to the outside of the three-dimensional integrated circuit 140 through the edge bumps EBP, the vias VA, the wiring layer ML, the plurality of devices 212a and 212b, and the package bumps PKBP.

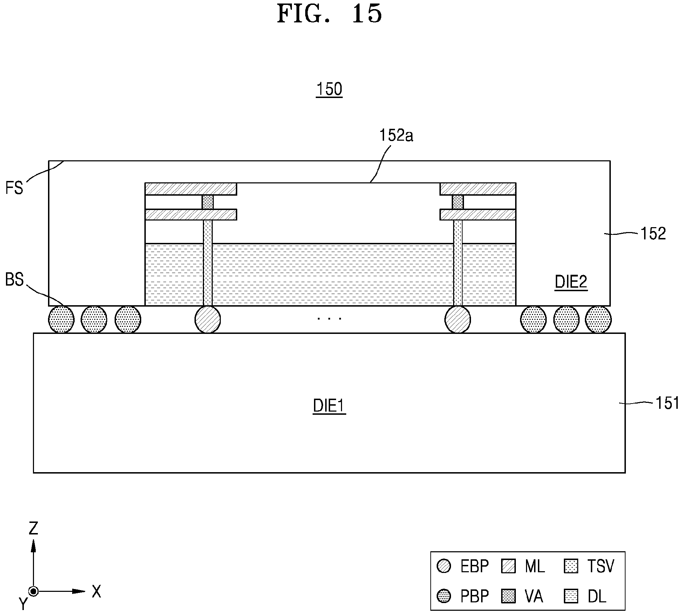

FIG. 15 shows a three-dimensional integrated circuit 150 according to an example embodiment.

Referring to FIG. 15, the three-dimensional integrated circuit 150 may include a first die 151 and a second die 152 that are stacked in the vertical direction Z. The second die 152 may have a first surface or the front side FS and a second surface or the backside BS, which are opposite each other. The second die 152 may include a functional block 152a arranged on the backside BS and a plurality of conductive terminals arranged on the backside BS. For example, the functional block 152a may correspond to F2B IP.

The first die 151 and the second die 152 may be electrically connected to each other through the plurality of conductive terminals. The plurality of conductive terminals may refer to conductive materials arranged between the first die 151 and the second die 152. For example, the plurality of conductive terminals may be bumps, micro-bumps, solder balls, etc. For example, the plurality of conductive terminals may include conductive patterns, and in this case, the first and second dies 151 and 152 may be connected to each other by HCB.

In detail, the plurality of conductive terminals may include: first bumps arranged under the functional block 152a and overlapping the functional block 152a in the vertical direction Z; and second bumps not overlapping the functional block 152a in the vertical direction Z. The first bumps may include a plurality of edge conductive terminals or a plurality of edge bumps EBP arranged on an edge region of the functional block 152a. The second bumps may include peripheral bumps PBP.

The functional block 152a may include: the device layer DL arranged on the backside BS of the second die 152; a metal layer or the wiring layer ML, which is arranged in the vertical direction Z with respect to the device layer DL; and a plurality of TSVs TSV. A plurality of devices, for example, transistors, may be arranged in the device layer DL, and the plurality of edge bumps EBP may not be electrically connected to (i.e., may be electrically isolated from) the plurality of devices arranged in the device layer DL of the functional block 152a. The wiring layer ML may include a plurality of wiring patterns, and the plurality of wiring patterns may be electrically connected to an external device outside of the functional block 152a. For example, the wiring layer ML may include a plurality of wiring layers that are spaced apart from each other in the vertical direction Z, and the plurality of wiring layers may be electrically connected to each other through vias VA. The plurality of TSVs TSV may respectively be connected between the plurality of conductive terminals, for example, the plurality of edge bumps EBP, and the plurality of wiring patterns, and may each extend in the vertical direction Z.

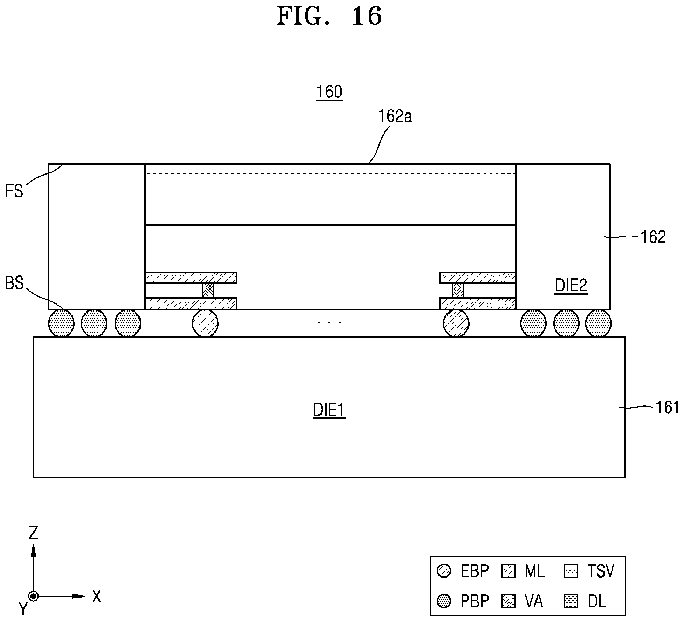

FIG. 16 shows a three-dimensional integrated circuit 160 according to an example embodiment.

Referring to FIG. 16, the three-dimensional integrated circuit 160 corresponds to a modified example of the three-dimensional integrated circuit 150 of FIG. 15, and hereinafter, the differences from the three-dimensional integrated circuit 150 are mainly described. The three-dimensional integrated circuit 160 may include a first die 161 and a second die 162 that are stacked in the vertical direction Z. The second die 162 may include a functional block 162a arranged on the front side FS and a plurality of conductive terminals arranged on the backside BS. For example, the functional block 162a may correspond to F2F IP.

In detail, the plurality of conductive terminals may include: first bumps arranged under the functional block 162a and overlapping the functional block 162a in the vertical direction Z; and second bumps not overlapping the functional block 162a in the vertical direction Z. The first bumps may include , a plurality of edge conductive terminals or a plurality of edge bumps EBP arranged on an edge region of the functional block 162a. The second bumps may include peripheral bumps PBP.

The functional block 162a may include: the device layer DL arranged on the front side FS of the second die 162; and a metal layer or the wiring layer ML, which is arranged in the vertical direction Z with respect to the device layer DL. A plurality of devices, for example, transistors, may be arranged in the device layer DL, and the plurality of edge bumps EBP may not be electrically connected to (i.e., may be electrically isolated from) the plurality of devices arranged in the device layer DL of the functional block 162a. The wiring layer ML may include a plurality of wiring patterns, and the plurality of wiring patterns may be electrically connected to an external device outside of the functional block 162a. For example, the wiring layer ML may include a plurality of wiring layers that are spaced apart from each other in the vertical direction Z, and the plurality of wiring layers may be electrically connected to each other through vias VA.

As described above with reference to FIGS. 15 and 16, example embodiments may also be applied when the second dies 152 and 162, that is, upper dies, include the functional blocks 152a and 162a. By spacing the edge conductive terminals overlapping the edge regions of the functional blocks 152a and 162a of the upper dies apart from the boundaries of the functional blocks 152a and 162a by a distance that is greater than or equal to a minimum distance between the conductive terminals, short circuits or disconnections of the peripheral conductive terminals may be prevented. In addition, by smoothly transmitting power and/or signals between the dies through the conductive terminals overlapping the functional blocks 152a and 162a, the performance of the three-dimensional integrated circuits 150 and 160 may be improved. For example, the signal may be transmitted with high integrity, and minimal signal loss and distortion.

Furthermore, by arranging the conductive terminals overlapping the functional blocks 152a and 162a, the conductive terminals instead of dummy terminals may be arranged in regions adjacent to the functional blocks 152a and 162a, and accordingly, PPA of the three-dimensional integrated circuits 150 and 160 may be improved. In addition, by designing the functional blocks 152a and 162a including the conductive terminals and/or TSVs, the reliability of the conductive terminals may be improved, and in operations of designing the three-dimensional integrated circuits 150 and 160, the functional blocks 152a and 162a may be re-used without additional verification with respect thereto.

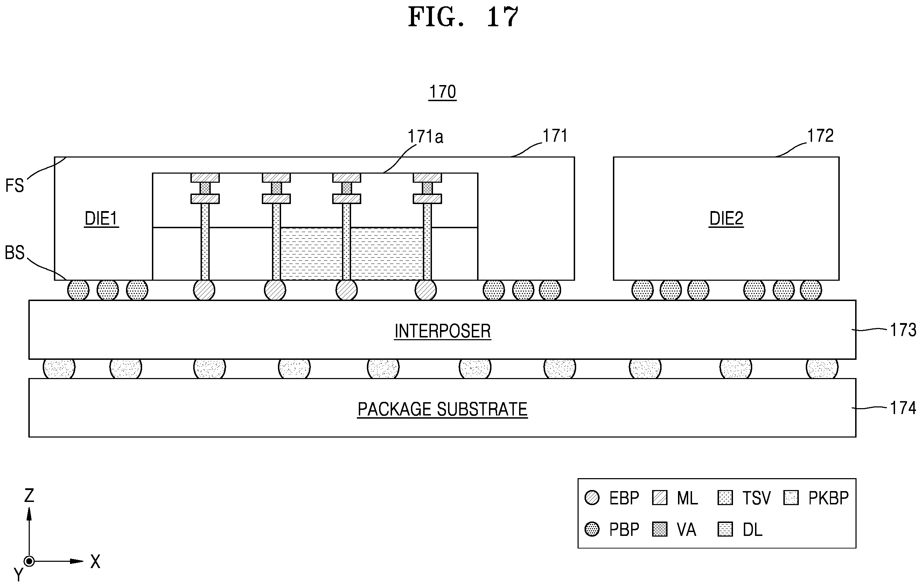

FIG. 17 shows a three-dimensional integrated circuit 170 according to an example embodiment.

Referring to FIG. 17, the three-dimensional integrated circuit 170 may include a first die 171 and a second die 172 that are adjacent to each other in the first direction X. The first and second dies 171 and 172 may be arranged on an interposer 173 and may be electrically connected to the interposer 173 through a plurality of conductive terminals. The interposer 173 may include a plurality of TSVs, and the first and second dies 171 and 172 may be electrically connected to each other through the plurality of conductive terminals and the TSVs within the interposer 173. The interposer 173 may be arranged on a package substrate 174, and may be connected to the package substrate 174 through a plurality of package bumps PKBP. For example, the first die 171 may correspond to a modified example of the second die 152 of FIG. 15.

In an example embodiment, the three-dimensional integrated circuit 170 may further include at least one die arranged above the first die 171 and/or at least one die arranged above the second die 172. In an example embodiment, the first die 171 may correspond to a base die, the second die 172 may correspond to a logic die, and a plurality of core dies or memory dies may be arranged above the first die 171. In an example embodiment, the first die 171 may correspond to a logic die, the second die 172 may correspond to a base die, and a plurality of core dies or memory dies may be arranged above the second die 172.

The first die 171 may include a functional block 171a arranged on the backside BS of the first die 171. The functional block 171a may correspond to an example of the functional block 152a of FIG. 15. For example, the functional block 171a may correspond to F2B IP. The plurality of conductive terminals may include edge bumps EBP overlapping the functional block 171a in the vertical direction Z and peripheral bumps PBP not overlapping the functional block 171a in the vertical direction Z. The plurality of conductive terminals may be arranged depending on example embodiments illustrated in FIGS. 1 to 16.

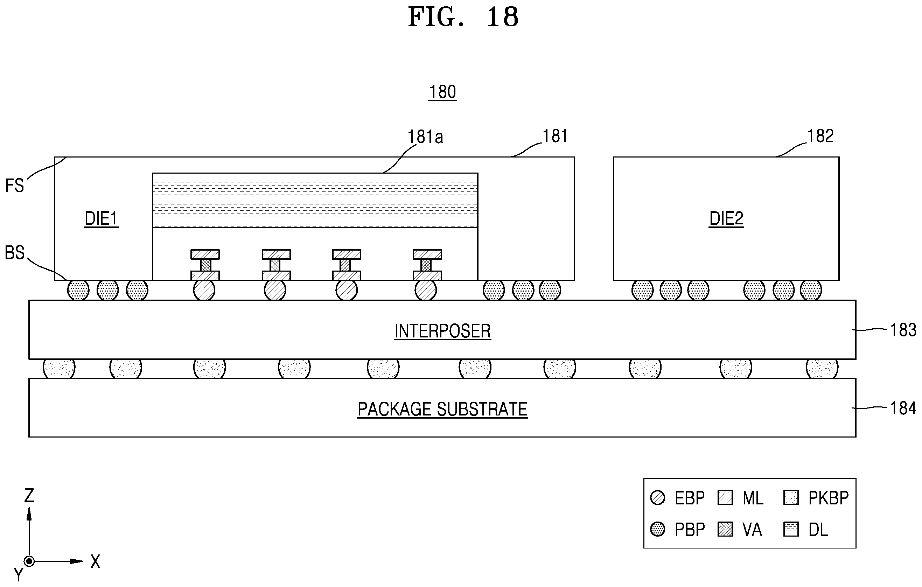

FIG. 18 shows a three-dimensional integrated circuit 180 according to an example embodiment.

Referring to FIG. 18, the three-dimensional integrated circuit 180 may include a first die 181 and a second die 182 that are adjacent to each other in the first direction X. The first and second dies 181 and 182 may be arranged on an interposer 183 and may be electrically connected to the interposer 183 through a plurality of conductive terminals. The interposer 183 may include a plurality of TSVs, and the first and second dies 181 and 182 may be electrically connected to each other through the plurality of conductive terminals and the TSVs within the interposer 183. The interposer 183 may be arranged on a package substrate 184, and may be connected to the package substrate 184 through a plurality of package bumps PKBP. For example, the first die 181 may correspond to a modified example of the second die 162 of FIG. 16.

In an example embodiment, the three-dimensional integrated circuit 180 may further include at least one die arranged above the first die 181 and/or at least one die arranged above the second die 182. In an example embodiment, the first die 181 may correspond to a base die, the second die 182 may correspond to a logic die, and a plurality of core dies or memory dies may be arranged above the first die 181. In an example embodiment, the first die 181 may correspond to a logic die, the second die 182 may correspond to a base die, and a plurality of core dies or memory dies may be arranged above the second die 182.

The first die 181 may include a functional block 181a arranged on the backside BS of the first die 181. The functional block 181a may correspond to an example of the functional block 162a of FIG. 16. For example, the functional block 181a may correspond to F2F IP. The plurality of conductive terminals may include edge bumps EBP overlapping the functional block 181a in the vertical direction Z and peripheral bumps PBP not overlapping the functional block 181a in the vertical direction Z. The plurality of conductive terminals may be arranged depending on example embodiments illustrated in FIGS. 1 to 16.

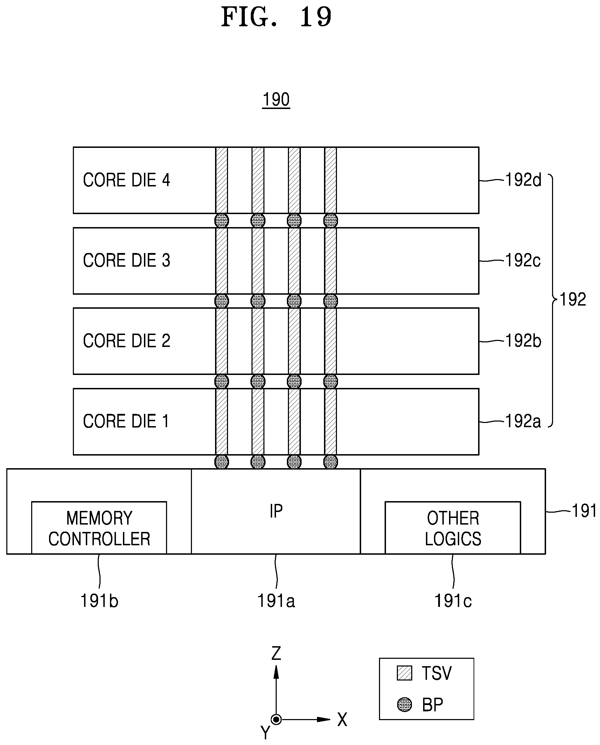

FIG. 19 shows an HBM apparatus 190 according to an example embodiment.

Referring to FIG. 19, the HBM apparatus 190 may include a logic die 191 and a memory die 192, and the memory die 192 may include first to fourth core dies 192a to 192d stacked on the logic die 191 in the vertical direction Z. Depending on example embodiments, the HBM apparatus 190 may correspond to a three-dimensional memory device, a stacked memory device, or a three-dimensional HBM device. The HBM apparatus 190 may correspond to one example embodiment of the three-dimensional integrated circuits illustrated in FIGS. 1A to 18, and the descriptions provided above with reference to FIGS. 1A to 18 may also be applied to the HBM apparatus 190.

The logic die 191 and the first to fourth core dies 192a to 192d may each include TSVs. The TSVs within the logic die 191 may extend in the vertical direction Z through the logic die 191, and the TSVs in each of the first to fourth core dies 192a to 192d may extend in the vertical direction Z through each of the first to fourth core dies 192a to 192d. Bumps BP may be arranged between the logic die 191 and the first to fourth core dies 192a to 192d. For example, the bumps BP may be micro-bumps. For example, the bumps BP may be conductive bumps including copper, cobalt, nickel, etc. The logic die 191 and the first to fourth core dies 192a to 192d may be electrically connected to each other through the TSVs and the bumps BP.

The logic die 191 may include a functional block 191a, a memory controller 191b, and other logics 191c. For example, the functional block 191a may be implemented as part of an interface circuit. Bumps BP arranged above the functional block 191a may be arranged according to example embodiments illustrated in FIGS. 1A to 18. In an example embodiment, the other logics 191c may include core logics such as a central processing unit (CPU), a graphics processing unit (GPU):, or an neural processing unit (NPU). In an example embodiment, the other logics 191c may include interface logics. For example, the interface logics may include a universal chiplet interconnect express (UCIe) module for supporting interface protocols between semiconductor chips or semiconductor dies.

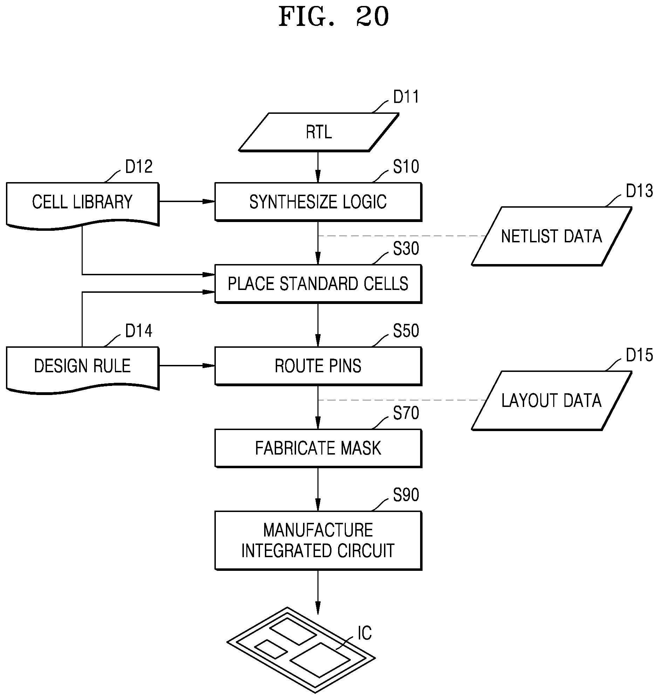

FIG. 20 is a flowchart showing a method of manufacturing a three-dimensional integrated circuit, according to an example embodiment.

Referring to FIG. 20, a method for manufacturing a three-dimensional integrated circuit IC may include a plurality of operations S10, S30, S50, S70, and S90. A cell library (or standard cell library) D12 may include information about standard cells, for example, information about functions, characteristics, layouts, etc. In an example embodiment, the cell library D12 may define not only functional cells that generate output signals from input signals, but also a tap cell, a filler cell, a power switch cell, and a dummy cell. A design rule D14 may include requirements that a layout of the three-dimensional integrated circuit IC should comply with. For example, the design rule D14 may include requirements regarding a space between patterns on the same layer, the minimum width of a pattern, a routing direction of a wiring layer, etc. According to an example embodiment, the design rule D14 may include a bump minimum space, a space between a boundary of a functional block and an edge bump, a space between edge bumps, a space between internal bumps, a space between an edge bump and an internal bump, etc.

In operation S10, a logic synthesis operation may be performed to generate netlist data D13 from RTL data D11. For example, a semiconductor design tool (for example, a logic synthesis tool) may perform logic synthesis by referring to the cell library D12 from the RTL data D11, and may generate the netlist data D13 including a bitstream or a netlist. The netlist data D13 may correspond to input of place and routing described later.

In operation S30, standard cells may be placed. For example, a semiconductor design tool (for example, place and route (P&R) tool) may place standard cells used in the netlist data D13 by referring to the cell library D12. In operation S50, pins of the standard cells may be routed. For example, the semiconductor design tool may generate interconnections to electrically connect output pins and input pins of the placed standard cells, and may generate layout data D15 to define the placed standard cells and the generated interconnections. The interconnections may include a via of a via layer and/or patterns of wiring layers. The semiconductor design tool may refer to the design rule D14 while routing the pins of the cells. Operation S50 alone, or operation S30 and operation S50 together, may be referred to as a method of designing a three-dimensional integrated circuit.

In an example embodiment, as illustrated in FIGS. 1A to 19, a three-dimensional integrated circuit includes vertically stacked dies, and at least one of the dies may include at least one functional block. In this case, in an operation of designing a functional block, by designing a functional block including a plurality of conductive terminals, for example, a plurality of bumps or a plurality of conductive patterns, and/or a plurality of TSVs, the reliability of the conductive terminals may be improved, and the functional block may be re-used without additional verification with respect thereto in an operation of designing a three-dimensional integrated circuit.

In operation S70, an operation of fabricating a mask may be performed. For example, optical proximity correction (OPC) for correcting distortion such as refraction caused by the characteristics of light in photolithography may be applied to the layout data D15. Patterns on the mask may be defined to form patterns to be arranged on a plurality of layers based on the OPC-applied data, and at least one mask (or photomask) for forming patterns of each of the plurality of layers may be fabricated.

In operation S90, an operation of manufacturing the three-dimensional integrated circuit IC may be performed. For example, the three-dimensional integrated circuit IC may be manufactured by patterning the plurality of layers by using the at least one mask fabricated in operation S70. Operation S90 may include front-end-of-line (FEOL) operations, including, for example, an operation of planarizing and cleaning a wafer, an operation of forming a trench, an operation of forming a well, an operation of forming a gate line, and an operation of forming a source and a drain. Through FEOL, individual devices, for example, a transistor, a capacitor, and a resistor, may be formed on a substrate. In addition, operation S90 may also include back-end-of-line (BEOL) operations, including, for example, an operation of siliciding gate, source, and drain regions, an operation of adding a dielectric, an operation of planarization, an operation of forming a hole, an operation of adding a metal layer, an operation of forming a via, and an operation of forming a passivation layer. Through BEOL, individual devices, for example, a transistor, a capacitor, and a resistor, may be interconnected. In some example embodiments, operation S90 may further include middle-of-line (MOL) operations that may be performed between the FEOL and the BEOL, and contacts may be formed on the individual devices. Next, the three-dimensional integrated circuit IC may be packaged in a semiconductor package and may be used as a component in various applications.

While aspects of example embodiments have been particularly shown and described, it will be understood that various changes in form and details may be made therein without departing from the scope of the following claims.

## Claims

1. A three-dimensional integrated circuit (10) comprising:
a first die (11) having a first surface (FS) and a second surface (BS) opposite each other; and
a second die (12) vertically stacked on the first surface (FS) of the first die (11),
wherein the first die (11) comprises:
a functional block (111) arranged on the first surface (FS) of the first die (11); and
a plurality of conductive terminals arranged on the functional block (111) and electrically connecting the first die (11) to the second die (12),
wherein the plurality of conductive terminals comprise a plurality of edge conductive terminals (EBP) arranged on an edge region of the functional block (111), and
wherein the plurality of edge conductive terminals (EBP) are each spaced apart from a boundary (BD) of the functional block (111) by a first distance (D1) that is greater than or equal to a minimum distance (S) between the plurality of conductive terminals.

2. The three-dimensional integrated circuit (10) of claim 1, wherein a distance between adjacent edge conductive terminals (EBP) among the plurality of edge conductive terminals (EBP) corresponds to a second distance (D2) that is between the first distance (D1) and twice the first distance (D1).

3. The three-dimensional integrated circuit (10) of claim 2, wherein the plurality of conductive terminals (EBP) further comprise a plurality of internal conductive terminals (IBP) arranged on an inner region of the functional block (111) that is surrounded by the edge region, and
wherein the plurality of internal conductive terminals (IBP) comprise:
a first internal conductive terminal (IBP) spaced apart from one of the plurality of edge conductive terminals (EBP) by the second distance (D2);
a second internal conductive terminal (IBP) spaced apart from the first internal conductive terminal (IBP) by the second distance (D2); and
a third internal conductive terminal (IBP) spaced apart from the first internal conductive terminal (IBP) by a third distance that is different from the second distance (D2).

4. The three-dimensional integrated circuit (10) of any preceding claim, wherein the plurality of conductive terminals comprise at least one of bumps, micro-bumps, and solder balls.

5. The three-dimensional integrated circuit (10) of any of claims 1 to 3, wherein the plurality of conductive terminals comprise conductive patterns (EP, PP) on the first surface, and
wherein the first die (11) and the second die (12) are connected to each other by hybrid copper bonding (HCB).

6. The three-dimensional integrated circuit (10) of any preceding claim, wherein the functional block (111) comprises:
a device layer (DL) comprising a plurality of devices;
a wiring layer (ML) comprising a plurality of wiring patterns; and
a plurality of through-silicon vias (TSVs) respectively connected between the plurality of conductive terminals and the plurality of wiring patterns, and extending along a vertical direction (Z).

7. The three-dimensional integrated circuit (10) of claim 6, wherein the plurality of conductive terminals are electrically isolated from the plurality of devices.

8. The three-dimensional integrated circuit (10) of claim 6 or claim 7, wherein the plurality of wiring patterns are electrically connected to an external device outside of the functional block (111).

9. The three-dimensional integrated circuit (10) of any of claims 6-8, wherein the first die (11) further comprises a plurality of package bumps (PKBP) arranged on the second surface (BS) of the first die (11), and
wherein the plurality of wiring patterns are electrically connected to the plurality of package bumps (PKBP).

10. The three-dimensional integrated circuit (10) of any preceding claim, wherein the first die (11) further comprises a plurality of peripheral conductive terminals (PBP) arranged on the first surface (FS) and offset from the functional block (111), and
wherein the first die (11) and the second die (12) are electrically connected to each other through the plurality of conductive terminals and the plurality of peripheral conductive terminals (PBP).

11. A three-dimensional integrated circuit (20) comprising:
a first die (21) having a first surface (FS) and a second surface (BS) opposite each other; and
a second die (22) vertically stacked on the first surface (FS) of the first die (21),
wherein the first die (21) comprises:
a functional block (211) arranged on the second surface (BS); and
a plurality of conductive terminals arranged on the first surface (FS), overlapping the functional block (211) along a vertical direction (Z), and electrically connecting the first die (21) to the second die (22),
wherein the plurality of conductive terminals comprise a plurality of edge conductive terminals (EBP) overlapping an edge region of the functional block, and
wherein the plurality of edge conductive terminals (EBP) are each spaced apart from a boundary of the functional block (211) by a first distance (D1) that is greater than or equal to a minimum distance (S) between the plurality of conductive terminals.

12. The three-dimensional integrated circuit (20) of claim 11, wherein a distance between adjacent edge conductive terminals (EBP) among the plurality of edge conductive terminals (EBP) corresponds to a second distance (D2) that is between the first distance (D1) and twice the first distance (D1).

13. The three-dimensional integrated circuit (20) of claim 12, wherein the plurality of conductive terminals further comprise a plurality of internal conductive terminals (IBP) overlapping an inner region of the functional block (211) that is surrounded by the edge region, and
wherein the plurality of internal conductive terminals (IBP) comprise:
a first internal conductive terminal (IBP) spaced apart from one of the plurality of edge conductive terminals (EBP) by the second distance (D2);
a second internal conductive terminal (IBP) spaced apart from the first internal conductive terminal (IBP) by the second distance (D2); and
a third internal conductive terminal (IBP) spaced apart from the first internal conductive terminal (IBP) by a third distance that is different from the second distance (D2).

14. The three-dimensional integrated circuit (20) of any of claims 11-13, wherein the plurality of conductive terminals comprise at least one of bumps, micro-bumps, and solder balls.

15. The three-dimensional integrated circuit of any of claims 11-13, wherein the plurality of conductive terminals comprise conductive patterns (EP, PP) on the first surface (FS), and
wherein the first die (11) and the second die (12) are connected to each other by hybrid copper bonding (HCB).
